# NEUE EUROPÄISCHE PATENTSCHRIFT

(11) **EP 0 760 936 B2**
(45) Veröffentlichungstag und Bekanntmachung des Hinweises auf die Entscheidung über den Einspruch: **16.03.2005**
(45) Hinweis auf die Patenterteilung: 29.07.1998
(21) Anmeldenummer: 95924202.5
(22) Anmeldetag: 17.05.1995
(51) Int. Cl.: G01G 3/147, G01L 1/22

(54) **Dehnungsmesstreifen-Aufnehmer und Modulationsverstärker für Brückenschaltungen**
Strain gauge sensor and modulation amplifier for bridge circuits
Capteur à jauges de contrainte et amplificateur de modulation pour un circuit à pont

(30) Priorität: 17.05.1994 DE 4417228
(43) Veröffentlichungstag der Anmeldung: 12.03.1997
(73) Patentinhaber: HBM Wägetechnik GmbH, 64293 Darmstadt (DE)
(72) Erfinder: Altwein, Michael, 64287 Darmstadt (DE)
(74) Vertreter: von Samson-Himmelstjerna, Friedrich R.
(86) Internationale Anmeldenummer: PCT/EP1995/001865
(87) Internationale Veröffentlichungsnummer: WO 1995/031701

(56) Entgegenhaltungen:
- DE-A- 2 262 755
- DE-A- 3 125 133
- DE-A- 3 330 841
- DE-A- 4 232 032
- FR-A- 2 670 901
- GB-A- 2 221 039
- US-A- 4 966 034
- PATENT ABSTRACTS OF JAPAN vol. 9 no. 76 (P-346) [1799] ,5.April 1985 & JP,A,59 208429 (TOKYO DENKI K.K.) 26.November 1984,
- PATENT ABSTRACTS OF JAPAN vol. 11 no. 40 (P-544) [2487] ,5.Februar 1987 & JP,A,61 209332 (TOKYO ELECTRIC CO LTD) 17.September 1986,
- PATENT ABSTRACTS OF JAPAN vol. 9 no. 24 (P-331) [1747] ,31.Januar 1985 & JP,A,59 168331 (FUJI DENKI SEIZO K.K.) 22.September 1984,
- REVIEW OF SCIENTIFIC INSTRUMENTS, Bd. 56, Nr. 7, Juli 1985 NEW YORK US, Seiten 1413-1416, K.D. HILL 'STRAIN-GAUGE TRANSDUCER SIGNAL CONDITIONING WITH SQUARE-WAVE AC EXCITATION AND THERMAL ERROR COMPENSATION'
- "Drucksensoren", G. Pfeifer, R. Werthschützky, VEB Verlag Technik Berlin, 1989, Seite 132-135

## Beschreibung

Zur genauen Widerstandsmessung werden die DMS dabei häufig in eine Brücke verschaltet.

Charakteristisch für derartige DMS-Aufnehmer ist ein sehr geringes Ausgangs- bzw. Meßsignal. Im Falle der häufig benutzten DMS-Aufnehmer mit Metallfolien-DMS beträgt das Ausgangssignal z.B. nur 2 mV pro Volt Brücken-Eingangsspannung. Solch kleine Signale müssen vor ihrer Messung und Weiterverarbeitung zuerst verstärkt werden. Aus Kostengründen und der Einfachheit halber greift man im allgemeinen auf eine Gleichspannungsversorgung und Gleichspannungsverstärkung zurück, obwohl diese aufgrund ihrer üblichen technischen Beschränkungen häufig Nachteile haben, nämlich Gleichspannungsfehler, wie Thermospannungsfehler oder Offsetspannungen im Verstärker, sowie übermäßiges Niederfrequenzrauschen im gesamten Schaltkreis. Thermospannungen können an den Anschlußpunkten der notwendigen Verkabelung zwischen der Widerstandsbrücke und nachgeschalteten Verstärkern auftreten, nämlich dann, wenn dort unterschiedliche Materialien und Temperaturen vorliegen.

Diese Fehler müssen auf einem noch akzeptablen Niveau gehalten bzw. das Meßsignal von diesen Fehlspannungen klar abgehoben werden. Um etwa die oben genannten Ausgangssignale von 2 mV pro Volt Eingangsspannung bereitstellen zu können, müssen verschiedene Maßnahmen ergriffen werden. Einerseits werden die Belastungsgrenzen der DMS-Aufnehmer häufig so ausgelegt, daß sie bereits bei Nennlast nahe den Ermüdungsgrenzen der verwendeten Materialien liegen. Als Folge bleiben nur sehr begrenzte Überlastreserven übrig, weshalb - abhängig von der jeweiligen Anwendung - kostenintensive Überlastschutz-Einrichtungen bereitgestellt werden müssen. Andererseits werden zur Vergrösserung des Ausgangssignals häufig sehr hohe Eingangsspannungen an den DMS-Aufnehmer gelegt, um ihn innerhalb seiner mechanischen Belastungsgrenzen halten zu können. Erhöhte Eingangsspannungen heizen jedoch die DMS-Aufnehmer-Widerstände und damit die gesamte Meßanordnung auf. Außerdem sind hohe Versorgungsspannungen nicht mit den Niedrigspannungsanforderungen heutiger elektronischer Schaltkreise kompatibel. Schließlich ist der Einsatz batteriebetriebener DMS-Aufnehmer aufgrund des hohen Leistungsverbrauches fast gänzlich ausgeschlossen.

Die oben genannten Meßfehler, wie thermoelektrische Effekte, Rauschen und Temperatureffekte in nachgeschalteten externen Verstärkern werden heutzutage häufig durch zusätzliche Wechselspannungsmodulations und -verstärkungstechniken vermindert. Diese Modulationsverstärkungstechniken sind aus der Literatur (z.B. "1993 Linear Applications Handbook Vol. II, A Guide to Linear Circuit Design", Seite 1 und die die Fig. 27 und 28 enthaltende Seite) bekannt, werden aber in der Praxis nur dann angewendet, wenn sich deren hohe Komplexität und Kosten vertreten lassen. - Ergänzend wird noch auf die US-PS'en 4,868,411 (ISHIHARA), 4,461,182 (JONES, JR. ET AL), 4,213,348 (REINERTSON ET AL), 4,155263 (FRANTZ), 4,064,456 (GORVE), 3,965,296 (ROBERTS), III), 3,665,746 (RUSSELL), 3,657,660 (PFERSCH), 3,617,878 (SENOUR), 3,354,703 (RUSSEL, JR. ET AL) und 3,224,256 (HASTINGS) verwiesen.

Weiterhin ist es aus der EP 0 319 176 B1 (TOLEDO SCALES) bekannt, Fehler - Nichtlinearitäten - des DMS-Aufnehmers, Temperatureffekte der Meßbrücke, sich auf den Nullpunkt und den Verstärkungsfaktor eines nachgeschalteten Verstärkers auswirkende Temperatureffekte sowie ein Driften dieses Verstärkungsfaktors aufwendig digital zu korrigieren. Hierzu ist in den DMS-Aufnehmer eine Einheit integriert, die aus folgenden Elementen besteht: eine DMS-Brücke, ein der DMS-Brücke nachgeschalteter Verstärker, ein Analog-zu-Digitalwandler, eine Mikroprozessoreinrichtung samt Speicher und ein elektronischer Schalter zum Ein- und Ausschalten der Brücken-Eingangsspannung. Dabei werden die Eingangsspannung über den elektronischen Schalter an die DMS-Brücke gelegt und über einen Verstärker weiter an einen Analog-zu-Digitalwandler geleitet und das digitalisierte Ausgangssignal des Wandlers einem Mikroprozessor zugeführt, der es mittels abgespeicherter Algorithmen unter Verwendung empirisch gefundener Korrekturformeln sowie gelisteter Korrekturwerte korrigiert. Das so erhaltene digitale Signal wird von der in den DMS-Aufnehmer integrierten Einheit an eine externe Steuer- und Verarbeitungseinrichtung weitergeleitet. Dieser DMS-Aufnehmer ist aufgrund seines sehr komplexen, integrierten Schaltkreises, inklusive mitintegrierter Mikroprozessoreinrichtung, nur für sehr kostenaufwendige Wägeeinrichtungen oder ähnliches einsetzbar. - Ergänzend wird noch auf die Literaturstelle: Technisches Messen tm, 53 Jahrgang, Heft 6/1986, Seiten 236-241 (KOWALSKI) verwiesen.

Ein gattungsgemäßer DMS-Aufnehmer ist aus der JP-A-59-208429 (NISHIYAMA) bekannt. Dieser ist für eine externe Wechselspannungsversorgung ausgelegt. Diese externe Versorgung mit Wechselspannung hat u. a. folgende Nachteile: Streukapazitäten im Verbindungskabel zwischen Versorgungsquelle und DMS-Aufnehmer führen zu einer Phasenverschiebung zwischen den beiden Versorgungssignalen an der Versorgungsquelle und dem DMS-Aufnehmer. Diese unerwünschte Phasenverschiebung wird von einem Trennverstärker nachträglich kompensiert, der mit in den DMS-Aufnehmer integriert ist.

Aus der Literatur (z.B. "Elektrische Meßtechnik", E. Schrüfer, Hanser-Verlag, 1992, insbesondere Seite 240 bis 243) sind weiterhin Trägerfrequenz-Brücken und Modulationsverstärker bekannt. Hierbei erzeugt ein Trägerfrequenzgenerator ein Wechselspannungssignal, das an eine DMS- bzw. Widerstandsbrücke gelegt wird. Das Brücken-Ausgangssignal wird über einen Verstärker - mit vor- und nachgeschaltetem Transformator (dient zur Veranschaulichung der Signalaufarbeitung) - an einen Demodulator weitergeleitet. Der Demodulator - in Form eines Umschalters - wird dabei vom Trägerfrequenzgenerator gesteuert. Der Transformator erzeugt dabei über einen als Nulleiter dienenden Mittenabgriff und zwei weitere Abgriffe zum einen das verstärkte originale und zum zweiten das hierzu vorzeichengespiegelte Wechselspannungssignal. Diese beiden Signale werden abwechselnd vom Umschalter des Demodulators zusammen mit dem Nullpunktsignal des Mittenabgriffes dem Schaltungsausgang zugeführt.

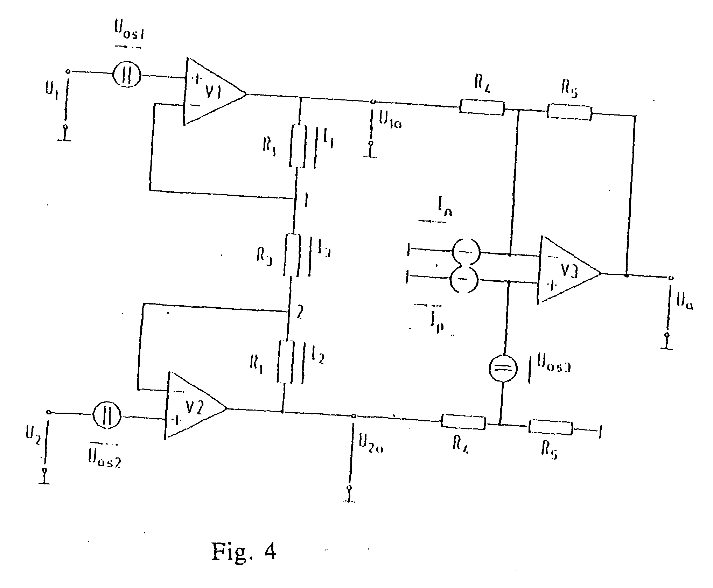

Als Wechselspannungsverstärker wird häufig ein symmetrischer Differenzverstärker mit nachgeschaltetem Subtrahierer verwendet (vgl. die beigefügte Fig. 4, welche dem Bild 3.20 in der obengenannten Literaturstelle Schrüfer entspricht). Da Meßgeräte für elektrische Spannungen einen "heißen" Eingang und eine Meßnull (häufig das Gehäuse des Meßgerätes) aufweisen, haben Verstärker für Widerstandsbrücken, deren eigentliches Signal die Differenz zweier Spannungen U₁ und U₂ (siehe Fig. 4) ist, zwei Eingänge. Dabei werden die Spannungen an beiden Eingängen auf dieselbe "Meßnull" bezogen. Ein dem Differenzverstärker nachgeschalteter Subtrahierer V₃ liefert als Ausgangssignal Uₐ die Differenz dieser beiden Spannungen. Damit liegt am Ausgang dieser Differenzverstärkereinheit eine auf die "Meßnull" bezogene Ausgangs-Spannung vor, als verstärktes Abbild der Differenz-Spannung am Eingang.

An diesem Ausgangssignal Uₐ kann über einen Inverter mit dem Verstärkungsfaktor -1 ein zweites negiertes Ausgangssignal -Uₐ abgeleitet werden. Diese beiden Signale können dann einem Demodulator zugeführt werden, der - wie oben beschrieben - mit auf eine "Meßnull" bezogenen Spannungen arbeitet. Dabei erweist sich die mit Uₒₛ₃ in Figur 4 bezeichnete Fehlspannung des Subtrahierers als ein ungünstiger Faktor, der noch unterdrückt werden muß. Außerdem muß der Inverter mit hoher Präzision arbeiten, was nur durch eine aufwendige Schaltung erreicht werden kann.

Die oben angesprochene Schaltungstechnik wird heutzutage weitgehend angewendet, da sie eine problemlose Weiterverarbeitung des Meßsignals gewährleistet. Die erhaltene Ausgangsspannung ist nämlich wieder einpolig gegen eine "Meßnull" verfügbar und somit von üblichen Meßgeräten oder sonstigen Elektronikschaltkreisen weiterverarbeitbar.

Die Erfindung betrifft einen Dehnungsmeßstreifen-Aufnehmer, in den integriert sind: ein DMS (Dehnungsmeßstreifen)-Teil, das aus wenigstens einem Dehnungsmeßstreifen aufgebaut ist, und eine Zusatzschaltung, die einen dem DMS-Teil nachgeschalteten Verstärker zur Verstärkung der Ausgangssignale des DMS-Teiles aufweist. Die Erfindung betrifft ferner einen Modulationsverstärker für Brückenschaltungen, insbesondere für einen Dehnungsmeßstreifen-Aufnehmer, der im wesentlichen besteht aus: einem als Rechteckgenerator ausgebildeten Modulator, einem Wechselspannungsverstärker und einem Demodulator, der als ein aus vier elektronischen Ein/Aus-Schaltern oder zwei elektronischen Wechselschaltern zusammengesetzter Brückengleichrichter ausgestattet ist.

Derartige DMS-Aufnehmer sind von großem praktischen Interesse, da sie kommerziell nutzbar sind, und z.B in vielen Wägeeinrichtungen in der Industrie eingesetzt werden.

Es sind bereits zahlreiche DMS-Aufnehmer mit integriertem DMS bekannt. Eine externe Elektronik speist dabei den DMS-Aufnehmer über ein Anschlußkabel mit einer Versorgungsspannung, empfängt dessen Meßsignal über dasselbe Kabel, verstärkt es und wertet es dann aus. Derartige DMS-Aufnehmer arbeiten in der Regel nach dem Prinzip von Widerstandsmessungen. Sie nutzen den Effekt aus, daß der Widerstand eines DMS proportional zu dessen Dehnung, d.h. dessen relative Längenänderung, und diese wiederum proportional zu der auf den DMS-Aufnehmer wirkenden Kraft ist.

So ist ein derartiger gattungsgemäßer Modulationsverstärker aus der US-A-3,965,429 (ROBERTS) bekannt. Dieser Modulationsverstärker hat jedoch den Nachteil, daß er den Charakter des Differenzsignals verändert, und deshalb den z.B. in der industriellen Wägetechnik üblichen, auf die Differenzsignale der DMS-Brücken eingerichteten externen Meßgeräte nicht ohne Veränderung vorschaltbar ist.

Ergänzend wird noch auf die FR-A 2 670 901 (PRECIA) sowie die US-PS'en 2,625,036 (COWLES) und 5,088,330 (TALMADGE) verwiesen.

Schließlich wird noch die US 4,966,034 genannt, die einen DMS-Aufnehmer mit integrierter DMS-Meßbrücke und integrierter Zusatzschaltung zeigt. Der DMS-Aufnehmer ist als Reifendruck-Meßmittel in einem Autoreifen eingebaut und wird über ein Hochfrequenzsignal von außen mit Spannung versorgt. Intern wird die Zusatzschaltung mit dem gleichgerichteten Hochfrequenzsignal versorgt und liefert ein Ausgangssignal, dessen Frequenz von der Verstimmung der DMS-Meßbrücke abhängt. Die Zusatzschaltung ist hierfür als Signalfrequenzwandler mit einem Modulator, einem Integrator-Verstärker und einem Schmitt-Trigger ausgestaltet.

Von diesem Stand der Technik ausgehend, zielt die Erfindung darauf ab, einen vergleichsweise einfachen, kostengünstigen DMS-Aufnehmer sowie einen insbesondere für diesen DMS-Aufnehmer benutzbaren einfachen Modulationsverstärker zur Verfügung zu stellen.

Dieses Ziel wird durch die Gegenstände der Ansprüche 1 und 12 erreicht.

Anspruch 1 stellt einen gattungsgemäßen Dehnungsmeßstreifen-Aufnehmer zur Verfügung, der sich dadurch auszeichnet, daß er für eine Gleichspannungs-Versorgung ausgelegt ist und die Zusatzschaltung als Modulationsverstärker aufgebaut ist, der im wesentlichen einen Modulator, der dem DMS-Teil als Wechselspannungsversorgung vorgeschaltet ist, dem Verstärker und einem Demodulator besteht.

Dabei können auf einfache Art und Weise Fehler des DMS-Teils und der Zusatzschaltung direkt an Ort und Stelle in dem DMS-Aufnehmer bei Montage des DMS-Aufnehmers korrigiert werden. Da DMS-Aufnehmer und Zusatz-Schaltung räumlich nahe beieinander angeordnet sind, können vorteilhaft - unabhängig von einer externen Beschaltung - etwaige Fehler der Zusatzschaltung und der DMS-Brücke kompensiert werden. Es können nämlich in einem Schritt die übliche Einstellung des Nullpunktes sowie die Korrektur der Temperaturfehler des DMS-Aufnehmers vorgenommen und die Temperaturabhängigkeit des Nullpunktes und des Verstärkungsfaktors sowie dessen Offset-driften kompensiert werden. Hierzu werden die Fehler am Ausgang des DMS-Aufnehmers gemessen und in einem Schritt - sowohl für den DMS-Teil als auch für die Zusatz-Schaltung - eliminiert bzw. kompensiert. Diese werden dann für alle Zeit unterdrückt.

Durch die Integration des DMS-Teiles und der speziellen Zusatzschaltung in den DMS-Aufnehmer werden insbesondere Wechselspannung-Kabelverbindungen kurz gehalten und somit die negativen Einflüsse etwaiger langer Zuleitungskabel vermieden. Hiermit wird vor allem das in der JP-A-59-208429 (NISHIYAMA) genannte Problem der unerwünschten Phasenverschiebung bereits von vornherein gelöst: Dank der Gleichspannungsversorgung des DMS-Aufnehmers kommt es überhaupt nicht zu einer solchen Phasenverschiebung. Die Wechselspannung-Verbindungsleitung zwischen Modulator und DMS-Teil ist durch die räumliche Nähe dieser beiden so kurz, daß die dort auftretende Phasenverschiebung vernachlässigbar ist. Vorteilhaft wird somit eine nachträgliche Phasenkorrektur wie bei der JP-A-59-208429 (NISHIYAMA) eingespart.

Die als Modulationsverstärker aufgebaute Zusatzschaltung bietet den Vorteil, daß das modulierte Signal direkt im DMS-Aufnehmer erzeugt und dort auch wieder in eine Gleichspannung demoduliert wird. Damit wird vermieden, daß Wechselspannungssignale, die über ein Kabel vom Meßaufnehmer zu einer externen Versorgungsrschaltung - und umgekehrt - geführt werden, durch kapazitive und induktive Kabeleigenschaften beeinflußt werden. Außerdem können Gleichspannungsfehler der DMS-Verschaltung durch den Einsatz des Modulationsverstärker effektiv unterdrückt werden.

Der DMS-Aufnehmer kann für allgemeine Meßaufgaben verwendet werden, insbesondere für handelsübliche Haushalts- oder Industriewaagen. Dank des einfachen Aufbaus der Zusatzschaltung kommt der gesamte DMS-Aufnehmer mit einer geringen Zahl an elektronischen Komponenten aus. Dies zeichnet sie gerade für die Verwendung von Wägevorrichtungen o.ä. aus, bei denen die Spannungsversorgungen von handelsüblichen Batterien bereitgestellt wird.

Bevorzugt ist das DMS-Teil eine aus mehreren DMS zusammengeschaltete DMS-Brücke. Die Brücke kann aber auch aus DMS und anderen Widerständen bestehen. Diese Maßnahme liefert eine meßempfindlichere Verschaltung der DMS.

In einer besonders bevorzugten Ausführungsform ist der Modulator ein Rechteckgenerator, der Demodulator im wesentlichen ein aus vier elektronischen Ein/Aus-Schaltern oder zwei elektronischen Wechselschaltern zusammengesetzter Brückengleichrichter und Demodulator und Modulator so miteinander verschaltet, daß das Rechtecksignal des Modulators das Schalten der vier elektronischen Ein/Aus-Schalter oder der zwei elektronischen Wechselschalter des Demodulators taktet. Der Vorteil dieser Ausführungsform liegt in der Verwendung eines Rechteckgenerators als Spannungsversorgung des DMS-Teils. Dieser kann eine in der Amplitude viel exakter einstellbare Eingangs- bzw. Versorgungsspannung liefern, als es z.B. übliche externe Generatoren für sinusförmige Versorgungsspannungen erlauben. Von extern zugeführte sinusförmige Signale würden zwar beim Leiten durch lange Kabel nicht in ihrer Form verzerrt, sondern lediglich phasenverschoben, haben aber den Nachteil, daß aufwendige und teuere Geräte zum Erzeugen einer stabilen, exakt einstellbaren Amplitude bereitgestellt werden müssen.

Der spezielle Demodulator stellt gerade in Verbindung mit der speziellen Verschaltung mit dem Rechteckgenerator als Modulator eine besonders elegante und einfache, störungsfreie Demodulation des modulierten Meßsignals bereit. Hierdurch wird der Differenzcharakter einer herkömmlichen DMS-Brücke, die mit einer Gleichspannung gespeist und auch ein Gleichspannungs-Ausgangssignal liefert, besonders effektiv beibehalten.

Somit wird das Ausgangssignal einer mit einer Gleichspannung gespeisten passiven Meßbrücke exakt simuliert - allerdings verstärkt. Bis auf die Verstärkung treten nach außen also keine Unterschiede zu einem passiven Meßaufnehmer auf.

Bei einer bevorzugten Ausführungsform weist die Zusatzschaltung einen dem Demodulator nachgeschalteten RC-Tiefpaßfilter auf. Dieser Filter eliminiert hochfrequente Spannungen, die von nicht idealen Eigenschaften der Schalter und Verstärker herrühren können. Der RC-Tiefpaßfilter kann aber in einem externen Schaltkreis bereitgestellt werden. Gegebenenfalls kann sogar das den DMS-Aufnehmer mit externen Auswertegeräten verbindende Kabel aufgrund seiner induktiven und kapazitiven Eigenschaften bereits als Filter dienen.

Bevorzugt ist der Verstärker im wesentlichen ein symmetrischer Differenzverstärker. Einerseits wahrt die Differenzverstärkung den Charakter der Differenzsignale am Ausgang einer DMS-Meßbrücke; andererseits unterdrückt die symmetrische Anordnung der elektronischen Komponenten weitgehend etwaige nicht ideale Eigenschaften dieser Komponenten. Insgesamt ist das verstärkte Ausgangssignal des Wechselspannungsverstärkers somit im wesentlichen frei von Gleichspannungs-Überlagerungen, in Form von Offset-Spannungen o.ä.

In einer bevorzugten Ausführungsform weist die Verschaltung der Ausgänge der beiden Verstärker des symmetrischen Differenzverstärkers zusätzlich (zu den üblichen Widerständen) noch einen temperaturabhängigen Widerstand zur Fehlerkompensation der Temperaturabhängigkeit des DMS-Ausgangssignals und des Verstärkungsfaktors auf. Üblicherweise werden temperaturabhängige Widerstände auch dem Versorgungsspannungseingang der DMS-Brücke vorgeschaltet. Diese gängige Methode garantiert jedoch keine zuverlässige Fehlerkompensation. Zudem ist dann die Abstimmung für einzelne unterschiedliche DMS-Aufnehmer aufwendig. Derartige Probleme treten bei der vorgenannten Maßnahme nicht auf. Es wird hiermit nämlich vorteilhaft die Temperaturabhängigkeit des DMS-Brückenausgangssignals kompensiert, und das Driften des Verstärkungsfaktors auf einfache Art und Weise unterdrückt. Dieses Driften tritt häufig dadurch auf, daß die übrigen den Verstärkungsfaktor bestimmenden Widerstände bei unterschiedlichen Temperaturen schwanken.

Bevorzugt wird den beiden Versorgungsspannungs-Eingängen der DMS-Brücke jeweils ein Widerstand vorgeschaltet. Damit kann der Leistungsverbrauch in der DMS-Brücke eingestellt werden. Folglich kann dieser Verbrauch bei Bedarf so herabgesetzt werden, daß der gesamte DMS-Aufnehmer sinnvoll mit im Handel erhältlichen Batterien ausreichend lang betrieben werden kann. Diese Maßnahme öffnet damit einen großen Markt für besonders kostengünstige Meßvorrichtungen.

Bevorzugt bildet der mit dem DMS-Teil und der Zusatz-Schaltung bestückte DMS-Aufnehmer einen passiven DMS-Aufnehmer nach. Dabei weist der DMS-Aufnehmer bevorzugt vier elektrische Anschlüsse auf, nämlich zwei für die Versorgungsspannung und zwei für das Ausgangssignal. Damit weist der DMS-Aufnehmer nach außen weiterhin vier Anschlußpunkte auf, von denen zwei für die Spannungsversorgung der DMS-Brücke - und der Zusatzschaltung - zuständig sind, und zwei das (vor-)verstärkte Ausgangssignal liefern. Ein Benutzer dieses DMS-Aufnehmers kann also von außen nicht erkennen, ob er einen passiven DMS-Aufnehmer, d.h. einen DMS-Aufnehmer ohne nachgeschalteten, integrierten (Vor-)Verstärker, oder einen erfindungsgemäßen DMS-Aufnehmer in Händen hat. An den erfindungsgemäßen DMS-Aufnehmer können also weiterhin alle weiterverarbeitenden externen Geräte wie gehabt angeschlossen werden. Ihnen wird jedoch nunmehr ein verstärktes Signal zugeführt.

Bevorzugt ist die Zusatz-Schaltung als Hybridstruktur auf Wärme gut leitendem Keramik aufgebaut. Die so erhaltene Einheit kann damit auf dasselbe Metall des DMS-Aufnehmers aufgeklebt werden, auf dem auch das DMS-Teil aufliegt. Damit befinden sich die DMS-Brücke und die Zusatzschaltung in einem isothermen zustand, der bei der Kompensation von Temperatureffekten besonders vorteilhaft ist.

Dem DMS-Aufnehmer kann bevorzugt ein Analog-zu-Digitalwandler und/oder ein Mikroprozessor nachgeschaltet werden. Der Analog-zu-Digitalwandler kann einer verbesserten Anschaltbarkeit an digitale Auswertegeräte dienen, wobei der Wandler alleine oder kombiniert mit einem Mikroprozessor ein digitales Kommunikationsprotokoll oder eine Vorverarbeitung des Signales bereitstellen kann.

Anspruch 12 stellt einen gattungsgemäßen Modulationsverstärker für Brückenschaltungen zur Verfügung, der sich inbesondere für eine der obengenannten Ausführungsformen des DMS-Aufnehmers eignet und sich dadurch auszeichnet, daß der Wechselspannungsverstärker als symmetrischer Differenzverstärker ausgestaltet ist, und der Eingang des symmetrischen Differenzverstärkers mit dem Ausgang der Brücke und der Eingang des Demodulators mit dem Ausgang des symmetrischen Differenzverstärkers derart koppelbar und der Demodulator derart gesteuert ist, daß der Differenzsignal-Charakter des Brückenschaltungs-Ausgangssignals erhalten bleibt. Dieser Modulationsverstärker ist dank seines einfachen Aufbaus für alle denkbaren Brückenschaltungen als (Vor-) Verstärkerschaltung geeignet, vor allem, wenn es darauf ankommt, einen kostengünstigen, leicht abstimmbaren, stabilen und nahezu temperaturunabhängigen Verstärker zu schaffen, der außerdem den Differenzcharakter des Brückenausgangssignals beibehält. Dieser Modulationsverstärker stellt nicht nur die Vorteile der Modulationsverstärkertechnik bzw. Trägerfrequenzmodulation zur Verfügung, sondern ermöglicht auch die gleichzeitige Nutzung bereits vorhandener einfacher Gleichspannungsversorgungen und damit einhergehender, anschließender Verstärkungs- oder Verarbeitungsmethoden.

Weitere Vorteile und Ausgestaltungen der Erfindung ergeben sich aus der nachfolgenden Beschreibung bevorzugter Ausführungsbeispiele. In dieser Beschreibung wird auf die beigefügte schematische Zeichnung Bezug genommen. In der Zeichnung zeigen:
- Fig. 1: eine Verschaltung eines eine DMS-Brücke und eine Zusatz schaltung aufweisenden DMS-Aufnehmers mit einer externen elektronischen Gleichspannungsversorgung und Datenverarbeitung;
- Fig. 2: ein Schaltschema einer DMS-Brücke mit Modulationsverstärker;
- Fig. 3: einen Ausschnitt aus einem Modulationsverstärker, welcher den Verstärkerteil und Fehlerkorrekturglieder zeigt;
- Fig. 4: einen symmetrischen Differenzverstärker mit nachgeschaltetem Subtrahierer gemäß dem Stand der Technik.

Im folgenden werden in sämtlichen Figuren für funktionsgleiche Teile gleiche Bezugszeichen verwendet.

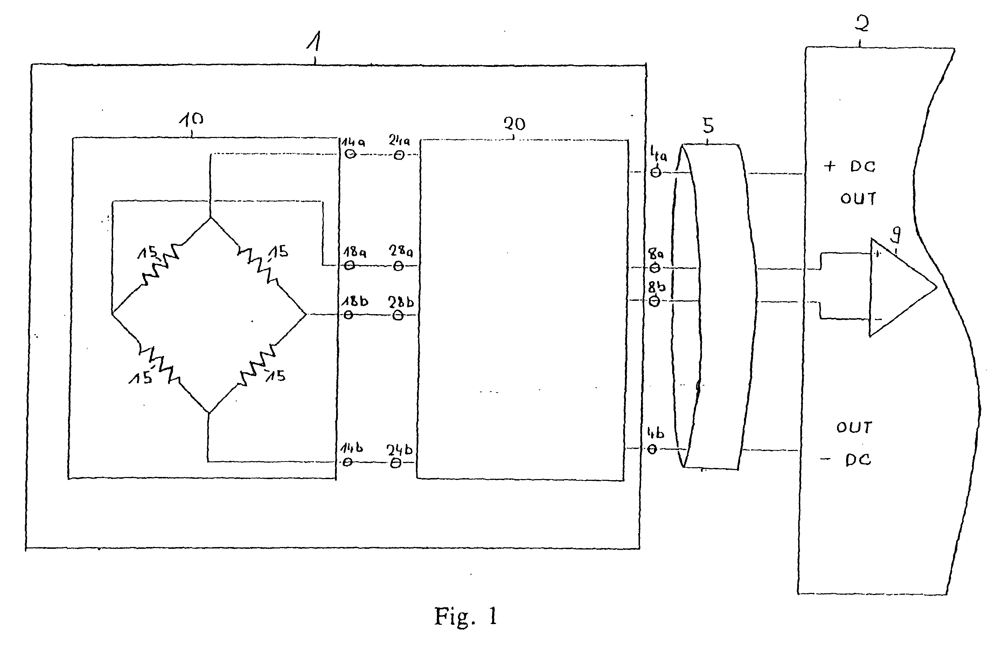

Fig. 1 veranschaulicht in schematischer Form die Verschaltung eines erfindungsgemäßen DMS-Aufnehmers bzw. Meßaufnehmers 1 mit einem gängigen externen elektronischen Versorgungs- und Verarbeitungsschaltkreis 2. Der Schaltkreis 2 versorgt den DMS-Aufnehmer 1 über zwei Anschlußpunkte 4a und 4b mit Gleichspannung. Zugleich empfängt er dessen Ausgangssignale über zwei Anschlußpunkte 8a und 8b und verarbeitet sie dann. In den Meßaufnehmer 1 sind eine DMS (Dehnungsmeßstreifen)-Brücke 10 und eine Zusatz-Schaltung 20 integriert. Der Aufbau der DMS-Brükke 10, die im wesentlichen aus den Brückeneingängen 14a und 14b, den Brückenausgängen 18a und 18b sowie den als Brückenzweige geschalteten DMS-Widerständen 15 besteht, und deren Integration in den DMS-Aufnehmer 1 sind bekannt. Sie werden deshalb hier nicht weiter beschrieben. Die Zusatz-Schaltung 20 besteht im wesentlichen aus einem Modulationsverstärker. Derartige Verstärker sind ebenfalls grundsätzlich bekannt, nicht aber deren Integration in den DMS-Aufnehmer 1 und die damit erzielbare große räumliche Nähe zwischen der DMS-Brücke 10 und der Zusatzschaltung 20. Der erfindungsgemäße DMS-Aufnehmer 1 unterscheidet sich demnach von einem gängigen passiven DMS-Aufnehmer, d.h. Meßufnehmer, der nur eine DMS-Brükke aufweist, durch seine Zusatzschaltung 20.

Der externe Schaltkreis 2 versorgt die Zusatz-Schaltung 20 über die Anschlußpunkte 4a und 4b des Meßaufnehmers 1 mit Gleichspannung. Diese wiederum versorgt die DMS-Brücke 10 an den beiden Anschlußpunkten 24a und 24b mit einer Wechselspannung. Gleichzeitig empfängt sie deren Meßsignale an den beiden Anschlußpunkten 28a und 28b. Die Zusatz schaltung 20 verarbeitet die Meßsignale und gibt sie über die beiden Anschlußpunkte 8a und 8b des Meßaufnehmers 1 an den externen Schaltkreis 2 weiter. Dort kann das Meßsignal zunächst mittels eines Verstärkers 9 auf herkömmliche Art und Weise verstärkt und dann verarbeitet werden. Der gesamte Signalaustausch zwischen dem Meßaufnehmer 1 und dem externen Schaltkreis 2 wird über ein Zuleitungskabel 5 geführt.

Offenbar läßt sich der erfindungsgemäße Meßaufnehmer 1 in genau gleicher Art und Weise wie ein gängiger passiver Meßaufnehmer an einen (gängigen) externen Versorgungsspannungs- und Signalauswertungsschaltkreis 2 anschließen. Benutzerseitig ist also keinerlei Umrüstung bei einem Wechsel zwischen passiven und erfindungsgemäßen Meßaufnehmern erforderlich. Äußerlich ist auch kein Unterschied ersichtlich. Jedoch stellt die Zusatz schaltung 20 ein verstärktes Signal an den beiden Anschlußpunkten 8a und 8b des Meßaufnehmers 1 bereit, das z.B. zehnmal größer als das Ausgangssignal der DMS-Brücke 10 an den Anschlußpunkten 28a und 28b ist. In diesem Beispiel weist der Meßaufnehmer 1 also einen zehnmal kleineren Speisestrom, eine zehnmal bessere Wägeauflösung oder eine zehnfache Überladekapazität auf.

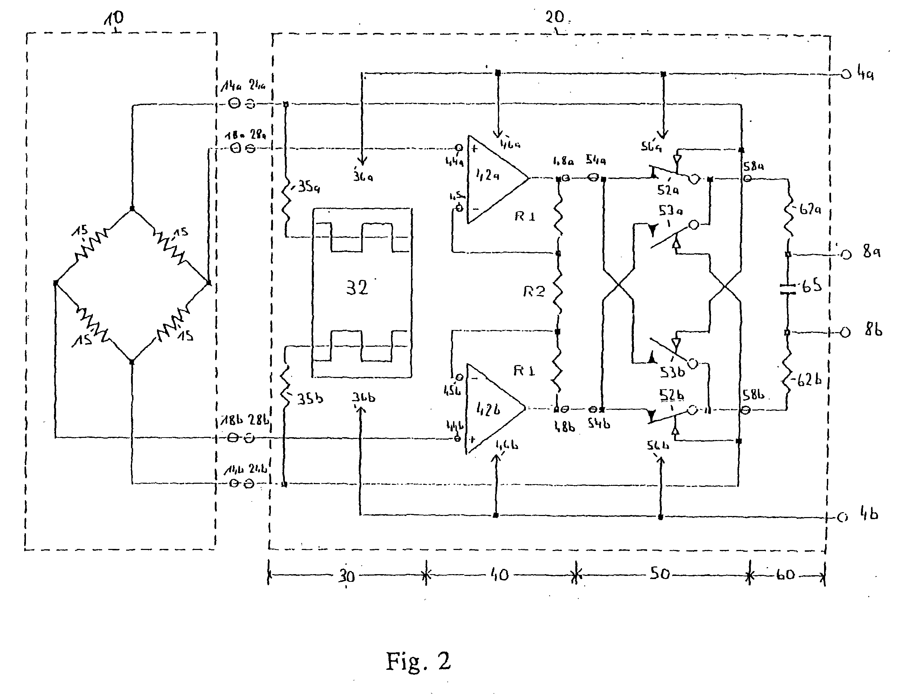

Fig. 2 zeigt ein bevorzugtes Schaltschema für die als Modulationsverstärker ausgebildete Zusatz-Schaltung 20. Der Modulationsverstärker besteht im wesentlichen aus einem Modulator 30, einem Wechselspannungsverstärker 40 und einem Demodulator 50. Zwischen den Demodulator 50 und die Signalausgangs-Anschlußpunkte 8a und 8b ist noch ein Tiefpaßfilter 60 geschaltet.

Die über die Anschlußpunkte 4a und 4b zugeführte Gleichspannung (siehe gestrichelte Linie) liegt parallel über Zweigleitungen 36a und 36b, 46a und 46b sowie 56a und 56b jeweils am Modulator 30, am Wechselspannungsverstärker 40 und am Demodulator 50 an. Der Modulator 30 enthält im wesentlichen einen Rechteckgenerator 32, welcher aus der Versorgungsspannung zwei um 180° phasenversetzte Wechselspannungszüge erzeugt. Der eine Wechselspannungszug wird als Eingangsspannung dem einen Eingang 14a der DMS-Brücke 10 zugeführt, und zwar über einen Widerstand 35a und den einen Zusatzschaltung-Ausgang 24a. Der andere Wechselspannungszug wird - über einen Widerstand 35b und den anderen Zusatzschaltung-Ausgang 24b - dem anderen Eingang 14b der DMS-Brücke 10 zugeführt.

Die zwei Ausgänge 18a und 18b der DMS-Brücke 10 sind über die beiden Zusatzschaltung-Eingänge 28a und 28b mit zwei Signal-Eingängen 44a und 44b des Wechselspannungsverstärkers 40 verbunden. Dieser ist im wesentlichen als symmetrischer Differenzverstärker ausgebildet, enthält also im wesentlichen zwei symmetrisch zu einem Widerstand R2 angeordnete Operationsverstärker 42a und 42b. Die (nicht-negierten) Eingänge 44a und 44b dieser beiden Operationsverstärker 42a und 42b bilden die Signaleingänge des Wechselspannungsverstärkers 40. Die beiden Ausgänge 48a und 48b der Operationsverstärker 42a und 42b sind jeweils über einen Widerstand R1 zu den negierten Operationsverstärkereingängen 45a und 45b zurückgeführt und miteinander über die Reihenschaltung: Widerstand R1 - Widerstand R2 - Widerstand R1 verbunden. Der Verstärkungsfaktor dieses symmetrischen Differenzverstärker errechnet sich also zu G = 1+2*R1/R2 und kann über die Widerstände R1 und R2 eingestellt werden. Die beiden Ausgänge 48a und 48b der Operationsverstärker 42a und 42b bilden die Ausgänge des Wechselspannungsverstärkers 40. An ihnen steht ein verstärktes Differenzsignal in Form einer Wechselspannung an, die in Frequenz und Phase mit der resultierenden Eingangsspannung der DMS-Brücke 10 übereinstimmt. Dieses Differenzsignal wird dem Demodulator 50 zugeführt.

Hierzu sind die beiden Verstärker-Ausgänge 48a und 48b mit zwei Eingängen 54a und 54b des Demodulators 50 verbunden. Dieser besteht gemäß Fig. 2 im wesentlichen aus vier analogen Schaltern 52a, 52b und 53a, 53b, welche die beiden Eingänge 54a und 54b mit zwei Ausgängen 58a und 58b des Demodulators 50 derart verbinden, daß jeder Eingang 54a und 54b abwechselnd mit jedem Ausgang 58a und 58b verbunden wird. Hierzu ist zunächst jeder Demodulator-Ausgang 58a und 58b mit einem aus zwei der vier Schalter 52a,b und 53a,b gebildeten Schalterpaar 52a und 53a bzw. 52b und 53b verbunden; nämlich, der Ausgang 58a mit den Schaltern 52a und 53a und der Ausgang 58b mit den Schaltern 52b und 53b. Außerdem verzweigt sich jeder Demodulator-Eingang 54a und 54b in zwei Zweigleitungen, die unterschiedlichen Schalterpaaren zugeführt sind, und zwar derart, daß die vier Zweigleitungen und die vier Schalter 52a,b und 53a,b einander umkehrbareindeutig zugeordnet sind. Das Um- bzw. EIN-/AUS-Schalten der vier Schalter 52a,b und 53a,b wird von den beiden rechteckförmigen Ausgangssignalen des Modulators 30 gesteuert, d.h. denjenigen Signalen, welche auch als Eingangsspannung der DMS-Brücke 10 zugeführt werden. Hierzu taktet jedes der beiden Modulator-Ausgangssignale gleichzeitig in jedem der beiden Schalterpaare 52a,53a und 52b,53b genau einen Schalter derart an, daß die beiden vom selben Signal getakten Schaltern 52a,53b oder 53a,52b abwechselnd öffnen und schließen und dabei untereinander stets komplementäre Schaltzustände einnehmen. Im Ergebnis bildet der Demodulator 50 einen Brückengleichrichter, welcher die Verbindung zwischen seinen Ein- und Ausgängen zyklisch im Takt der Modulationsfrequenz vertauscht. Damit liegt an den Ausgängen 58a und 58b des Demodulators 50 eine (differentielle) Gleichspannung an, deren Amplitude mit der der Wechselspannung an den Ausgängen 48a und 48b des Wechselspannungsverstärkers 40 übereinstimmt.

Die Schaltung stellt also eine phasenempfindliche Demodulation des Wechselspannungssignals in ein Gleichspannungsausgangssignal bereit.

Die Demodulator-Ausgänge 58a und 58b sind gemäß Fig. 2 über den einfachen RC-Tiefpaßfilter 60 mit den Ausgängen 8a und 8b des Meßaufnehmers 1 verbunden. Der Tiefpaßfilter 60 unterdrückt hochfrequente Spannungen, die aufgrund nicht perfekter Schalter und Verstärkerschaltungen auftreten können. Er besteht aus zwei in Reihe geschalteten Widerständen 62a und 62b und einem dazwischen angeordneten Kondensator 65. Der Ausgang des Tiefpaßfilters 60 wird über den Kondensator 65 abgegriffen. Die Spannung an den mit dem Tiefpaßabgriff verbundenen Ausgängen 8a und 8b des Meßaufnehmers 1 ist eine verstärkte, ansonsten aber exakte Nachbildung derjenigen Gleichspannung, welche die eingangs genannten, gängigen passiven Meßaufnehmers liefern: d.h. Meßaufnehmer, die im wesentlichen nur eine DMS-Brücke mit den Anschlußpunkten 14a,b und 18a,b bzw. 24a,b und 28a, b aufweisen. Bei diesem Vergleich ist noch zu berücksichtigen, daß den beiden Widerständen 62a und 62b exakt der halbe Wert des Ausgangswiderstandes des passiven Meßaufnehmers gegeben werden müßte.

Grundsätzlich kann der Tiefpaßfilter 60 auch weggelassen und entweder das (den externen Schaltkreis 2 und den Meßaufnehmer 1 verbindende) Zuleftungskabel 5 mit seinen kapazitiven und induktiven Eigenschaften als Tiefpaßfilter verwendet oder ein Tiefpaßfilter im externen Schaltkreis 2 bereitgestellt werden.

In der Ausführungsform der Fig. 2 wird auf einen symmetrischen Differenzverstärker 40 zurückgegriffen. Dabei bieten sich mindestens drei Vorteile. Erstens wird eine einfache Nachbildung des Differenzcharakters der DMS-Brücke 10 erzielt, wie aus der symmetrischen Anordnung der einzelnen Komponenten in Fig. 2 ersichtlich ist. Zweitens werden - dank der durchgehend symmetrischen Differenzstruktur der gesamten Schaltung - Fehler weitgehend unterdrückt, die z.B. von nicht perfekten elektronischen Bauteilen herrühren (z.B. ein Übersprechen der Steuersignale auf den Ausgang der Schalter 52a,b und 53a,b). Drittens wird dem demodulierten Signal durch die Differenzbildung keine Gleichspannung als Fehlspannung überlagert.

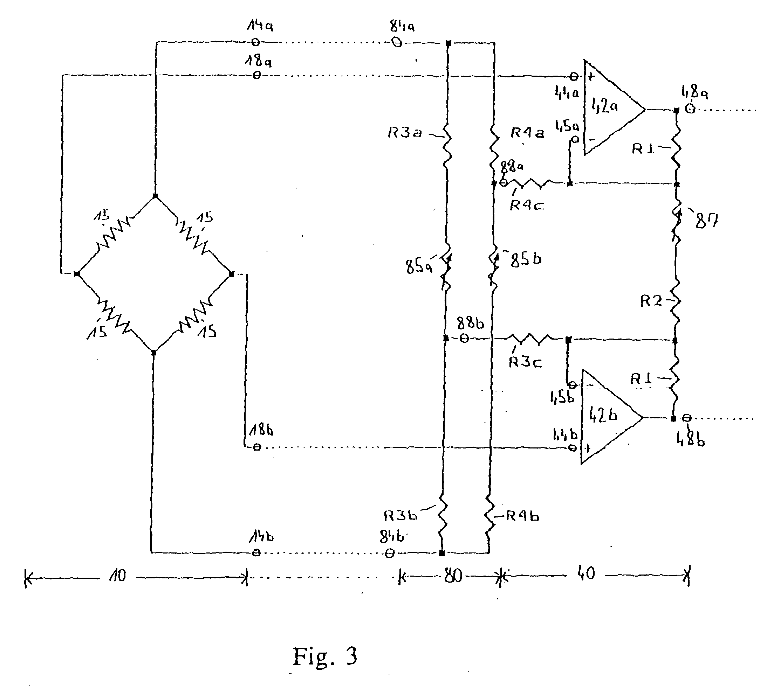

In dieser Ausführungsform kann eine unabhängige Kompensation von Fehlern der passiven Meßbrücke über zusätzliche Kompensationswiderstände erreicht werden. Fig. 3 zeigt ein Widerstandsnetzwerk, das dem symmetrischen Differenzverstärker 40 hinzugefügt wird. Das Widerstandsnetzwerk besteht im wesentlichen aus einer Widerstandsbrücke 80 und drei zusätzlichen Widerständen R3c, R4c und 87. Die Widerstandsbrücke 80 hat die beiden Brücken-Eingänge 84a und 84b und die beiden Brücken-Ausgänge 88a und 88b. Die Brücken-Eingänge 84a und 84b sind mit den Eingängen 14a und 14b der DMS-Brücke 10 parallelgeschaltet. Der Brücken-Ausgang 88a liegt über den Widerstand R4c am negierten Eingang 45a des Operationsverstärkers 42a; der Brücken-Ausgang 88b über den Widerstand R3c am negierten Eingang 45b des Operationsverstärkers 42b. Die Widerstandsbrücke 80 ist aus Widerständen R3a,b und R4a,b und temperaturabhängigen Widerständen 85a,b derart zusammengesetzt, daß der Widerstand R4a einen ersten Brückenzweig, der Widerstand R4b zusammen mit dem temperaturabhängigen Widerstand 85b eine zweiten Brückenzweig, der Widerstand R3b einen dritten Brückenzweig und der Widerstand R3a zusammen mit dem temperaturabhängigen Widerstand 85a einen vierten Brückenzweig bilden. Dabei greift der Brücken-Ausgang 88a der Widerstandsbrücke 80 zwischen dem ersten und dem zweiten Brückenzweig ab; der Brücken-Ausgang 88b zwischen dem dritten und dem vierten Brückenzweig. Der temperaturabhängige Widerstand 87 ist in Reihe mit dem Widerstand R2 geschaltet und bestimmt zusammen mit den Widerständen R1 und R2 den Verstärkungsfaktor des symmetrischen Differenzverstärkers 40.

Damit kompensieren die Widerstände R3a, b, c und R4a, b, c zusammen mit den temperaturabhängigen Widerständen 85a, b den Nullpunkt der DMS-Brücke 10, wobei außerdem noch die temperaturabhängigen Widerstände 85a, b eine temperaturabhängige Nullpunktsverschiebung der DMS-Brücke 10 und des symmetrischen Differenzverstärkers 40 sowie der temperaturabhängige Widerstand 87 die Temperaturabhängigkeit des DMS-Brückenausgangssignals und des Verstärkungsfaktors des symmetrischen Differenzverstärkers 40 ausgleichen.

## Patentansprüche

1. Dehnungsmeßstreifen-Aufnehmer (1), in welchen integriert sind:
a) ein DMS-Teil, das aus wenigstens einem DMS (Dehnungsmeßstreifen) aufgebaut ist, und
b) eine Zusatzschaltung (20), die einen dem DMS-Teil nachgeschalteten Verstärker (40) zur Verstärkung der Ausgangssignale des DMS-Teiles aufweist,
**dadurch gekennzeichnet, daß**
c) der Dehnungsmeßstreifen-Aufnehmer (1) für eine Gleichspannungsversorgung ausgelegt ist, und
d) die Zusatz-Schaltung (20) als Modulationsverstärker aufgebaut ist, der im wesentlichen aus einem Modulator (30), der dem DMS-Teil als Wechselspannungsversorgung vorgeschaltet ist, dem Verstärker (40) und einem Demodulator (50) besteht.

2. Dehnungsmeßstreifen-Aufnehmer (1) nach Anspruch 1, **dadurch gekennzeichnet, daß** das DMS-Teil eine aus mehreren DMS zusammengeschaltete DMS-Brücke (10) aufweist.

3. Dehnungsmeßstreifen-Aufnehmer (1) nach Anspruch 1 oder 2, **dadurch gekennzeichnet, daß**
a) der Modulator (30) ein Rechteckgenerator ist,
b) der Demodulator (50) im wesentlichen ein aus vier elektronischen Ein/Aus-Schaltern (52a,b; 53a,b) oder zwei elektronischen Wechselschaltern zusammengesetzter Brückengleichrichter ist, und
c) Demodulator (50) und Modulator (30) so miteinander verschaltet sind, daß das Rechtecksignal des Modulators (30) das Schalten der vier elektronischen Ein/Aus-Schalter (52a,b; 53a,b) oder der zwei elektronischen Wechselschalter des Demodulators (50) taktet.

4. Dehnungsmeßstreifen-Aufnehmer (1) nach einem der vorstehenden Ansprüche, **dadurch gekennzeichnet, daß** die Zusatzschaltung (20) einen dem Demodulator (50) nachgeschalteten RC-Tiefpaßfilter (60) aufweist.

5. Dehnungsmeßstreifen-Aufnehmer (1) nach einem der vorstehenden Ansprüche, **dadurch gekennzeichnet, daß** der Verstärker (40) im wesentlichen ein symmetrischer Differenzverstärker ist.

6. Dehnungsmeßstreifen-Aufnehmer (1) nach Anspruch 5, **dadurch gekennzeichnet, daß** die Verschaltung der Ausgänge (48a,b) der beiden Verstärker (42a,b) des symmetrischen Differenzverstärkers (40) zusätzlich noch einen temperaturabhängigen Widerstand (87) zur Fehlerkompensation der Temperaturabhängigkeit des DMS-Ausgangssignals und des Verstärkungsfaktors aufweist.

7. Dehnungsmeßstreifen-Aufnehmer (1) nach einem der Ansprüche 4 bis 6, **dadurch gekennzeichnet, daß** den beiden Versorgungsspannungs-Eingängen (14a,b) der DMS-Brücke (10) jeweils ein Widerstand (35a,b) vorgeschaltet ist.

8. Dehnungsmeßstreifen-Aufnehmer (1) nach einem der vorstehenden Ansprüche, **dadurch gekennzeichnet, daß** der mit dem DMS-Teil sowie der Zusatz-Schaltung (20) bestückte Dehnungsmeßstreifen-Aufnehmer (1) einen passiven Dehnungsmeßstreifen-Aufnehmer nachbildet.

9. Dehnungsmeßstreifen-Aufnehmer (1) nach Anspruch 8, **gekennzeichnet durch** vier elektrische Anschlüsse, nämlich zwei für die Versorgungsspannung (4a,4b) und zwei für das Ausgangssignal (8a,8b).

10. Dehnungsmeßstreifen-Aufnehmer (1) nach einem der vorstehenden Ansprüche, **dadurch gekennzeichnet, daß** die Zusatz-Schaltung (20) als Hybridstruktur auf Keramik aufgebaut ist.

11. Dehnungsmeßstreifen-Aufnehmer (1) nach einem der vorstehenden Ansprüche, **dadurch gekennzeichnet, daß** dem Dehnungsmeßstreifen-Aufnehmer (1) ein Analog-zu-Digitalwandler und/oder ein Mikroprozessor nachgeschaltet ist.

12. Modulationsverstärker, der zum Verstärken des Ausgangs einer Brückenschaltung mit Dehnungsmeßstreifen eines Dehnungsmeßstreifen-Aufnehmers (1) nach einem der vorstehenden Ansprüche ausgestaltet ist, der im wesentlichen besteht aus:
a) einem als Rechteckgenerator (32) ausgebildeten Modulator (30),
b) einem Wechselspannungsverstärker (40), und
c) einem Demodulator (50), der als ein aus vier elektronischen Ein/Aus-Schaltern (52a,b; 53a,b) oder zwei elektrischen Wechselschaltern zusammengesetzter Brückengleichrichterausgestaltet ist,
**dadurch gekennzeichnet, daß**
d) der Wechselspannungsverstärker (40) als symmetrischer Differenzverstärker ausgestaltet ist, und
e) der Eingang des symmetrischen Differenzverstärkers mit dem Ausgang der Brückenschaltung und der Eingang des Demodulators mit dem Ausgang des symmetrischen Differenzverstärkers derart koppelbar und der Demodulator derart gesteuert ist, daß der Differenzsignal-Charakter des Brückenschaltungs-Ausgangssignals erhalten bleibt.

## Claims

1. Wire strain gauge pick-up (1) into which are integrated:
a) a WSG part which is constructed of at least one WSG (wire strain gauge), and
b) a supplementary circuit (20) which has an amplifier (40) connected in series with the WSG part for amplifying the output signals of the WSG part,
**characterised in that**
c) the wire strain gauge pick-up (1) is designed for a direct current power supply, and
d) the supplementary circuit (20) is constructed as a modulation amplifier which is essentially comprised of a modulator (30), which is connected ahead of the WSG part as an alternating current power supply, the amplifier (40) and a demodulator (50).

2. Wire strain gauge pick-up (1) according to claim 1, **characterised in that** the WSG part has a WSG bridge (10) connected together from a plurality of WSGs.

3. Wire strain gauge pick-up (1) according to claim 1 or 2, **characterised in that**
a) the modulator (30)is a square wave generator,
b) the demodulator (50) is essentially a bridge rectifier composed of four electronic on/off switches 52a, b; 53a, b) or two electronic change-over switches, and
c) demodulator (50) and modulator (30) are interconnected to one another in such a way that the square wave signal of the modulator (30) gives the timing for the switching of the four electronic on/off switches (52a, b; 53a, b) or of the two electronic change-over switches of the demodulator (50).

4. Wire strain gauge pick-up (1) according to one of the preceding claims, **characterised in that** the supplementary circuit (20) has a RC lowpass filter (60) connected in series with the demodulator (50).

5. Wire strain gauge pick-up (1) according to one of the preceding claims, **characterised in that** the amplifier (40) is essentially a symmetrical difference amplifier.

6. Wire strain gauge pick-up (1) according to claim 5, **characterised in that** the interconnection of the outputs (48a, b) of the two amplifiers (42a, b) of the symmetrical difference amplifier (40) has in addition a further temperature-dependent resistance (87) for compensating for errors from the temperature dependence of the WSG output signal and of the gain factor.

7. Wire strain gauge pick-up (1) according to one of the claims 4 to 6, **characterised in that** a resistance (35a, b) is connected ahead of each of the two supply voltage inputs (14a, b) of the WSG bridge (10).

8. Wire strain gauge pick-up (1) according to one of the preceding claims, **characterised in that** the wire strain gauge pick-up (1) equipped with the WSG part as well as the supplementary circuit (20) simulates a passive wire strain gauge pick-up.

9. Wire strain gauge pick-up (1) according to claim 8, **characterised by** four electric connections, namely two for the supply voltage (4a, 4b) and two for the output signal (8a, 6b).

10. Wire strain gauge pick-up (1) according to one of the preceding claims, **characterised in that** the supplementary circuit (20) is constructed as a hybrid structure on ceramic.

11. Wire strain gauge pick-up (1) according to one of the preceding claims, **characterised in that** an analogue-to-digital converter and/or a microprocessor is connected in series with the wire strain gauge pick-up (1).

12. Modulation amplifier which for amplifying the output of a bridge circuit is constructed with strain gauge strips of a strain gauge pick-up (1) according to one of the preceding claims which essentially consists of:
a) a modulator (30) constructed as a square wave generator (32),
b) an ac voltage amplifier (40), and
c) a demodulator (50) which is constructed as a bridge rectifier composed of four electronic on/off switches (52a, b; 53a, b) or two electric change-over switches,
**characterised in that**
d) the ac voltage amplifier (40) is constructed as a symmetric difference amplifier, and
e) the input of the symmetric difference amplifier can be coupled to the output of the bridge circuit and the input of the demodulator can be coupled to the output of the symmetric difference amplifier and the demodulator is controlled in such a way that the differential signal character of the bridge circuit output signal is retained.

## Revendications

1. Capteur à jauges de contrainte (1) dans lequel sont intégrés :
a) une partie jauge de contrainte, qui est formée d'une jauge de contrainte au moins, et
b) un montage additionnel (20) qui présente un amplificateur (40) intercalé en aval de la partie jauge de contrainte, pour amplifier le signal de sortie de la partie jauge de contrainte,
**caractérisé en ce que**
c) le capteur à jauges de contrainte (1) est aménagé pour une alimentation en tension continue, et
d) le circuit additionnel (20) est agencé comme un amplificateur à modulation, qui est essentiellement composé d'un modulateur (30), lequel est intercalé en amont de la partie jauge de contrainte comme fourniture d'alimentation en tension alternative, de l'amplificateur (40) et d'un démodulateur (50).

2. Capteur à jauges de contrainte (1) conforme à la revendication 1, **caractérisé en ce que** la partie jauge de contrainte se présente sous forme d'un pont de jauges de contrainte formé de plusieurs jauges de contrainte.

3. Capteur à jauges de contrainte (1) conforme à la revendication 1 ou 2, **caractérisé en ce que**
a) le modulateur (30) est un générateur de signal rectangulaire,
b) le démodulateur (50) est de manière essentielle constitué d'un redresseur en pont composé de quatre commutateurs tout ou rien (52a, b; 53a, b) ou de deux interrupteurs électroniques à bascule va et vient, et
c) le démodulateur (50) et le modulateur (30) sont branchés l'un à l'autre de telle manière que le signal rectangulaire du modulateur (30) synchronise la commutation des quatre commutateurs électroniques tout ou rien (52a, b; 53a, b) ou les deux interrupteurs électroniques à bascule va et vient du démodulateur (50).

4. Capteur à jauges de contrainte (1) conforme à l'une quelconque des revendications précédentes, **caractérisé en ce que** le montage additionnel (20) présente un filtre RC passe-bas (60) branché en aval du démodulateur (50).

5. Capteur à jauges de contrainte (1) conforme à l'une quelconque des revendications précédentes, **caractérisé en ce que** l'amplificateur (40) est, de manière essentielle, un amplificateur différentiel symétrique.

6. Capteur à jauges de contrainte (1) conforme à la revendication 5, **caractérisé en ce que** le câblage des sorties (48a, b) des deux amplificateurs (42a, b) de l'amplificateur différentiel symétrique (40) comporte en outre une résistance (87) qui dépend de la température pour compenser une erreur consécutive au fait que le signal de sortie du capteur à jauges de contraintes et le facteur d'amplification dépendent de la température.

7. Capteur à jauges de contrainte (1) conforme à l'une quelconque des revendications 4 à 6, **caractérisé en ce que** une résistance (35a, b) est branchée en série dans les deux entrées respectives d'alimentation en tension continue (14a, b) du pont de jauges de contrainte (10).

8. Capteur à jauges de contrainte (1) conforme à l'une quelconque des revendications précédentes, **caractérisé en ce que** le capteur à jauges de contrainte (1), muni de la partie à jauges de contrainte ainsi que du circuit additionnel (20) constitue un capteur passif à jauges de contrainte.

9. Capteur à jauges de contrainte (1) conforme à la revendication 8, **caractérisé en ce qu'**il comporte quatre connexions électriques, c'est-à-dire deux pour l'alimentation en tension (4a, 4b) et deux pour le signal de sortie (8a, 8b).

10. Capteur à jauges de contrainte (1) conforme à l'une quelconque des revendications précédentes, **caractérisé en ce que** le circuit additionnel (20) est réalisé selon une structure hybride sur de la céramique.

11. Capteur à jauges de contrainte (1) conforme à l'une quelconque des revendications précédentes, **caractérisé en ce que** le capteur à jauges de contrainte (1) est placé en amont d'un convertisseur analogique-numérique et/ ou d'un microprocesseur.

12. Amplificateur à modulation, qui, pour amplifier la sortie d'un montage en pont, est agencé avec des jauges de contrainte d'un capteur à jauges de contrainte (1) conformément à l'une des revendications précédentes, qui consiste de manière essentielle en :
a) un modulateur (30) formé d'un générateur de signal rectangulaire (32),
b) un amplificateur de tension alternative (40), et
c) un démodulateur (50) qui est agencé comme un redresseur en pont composé de l'un parmi quatre interrupteurs électroniques tout ou rien (52a, b ; 53a, b) ou bien de deux interrupteurs électriques à bascule va et vient,
**caractérisé en ce que**
d) l'amplificateur de tension alternative (40) est agencé comme un amplificateur différentiel symétrique, et
e) l'entrée de l'amplificateur différentiel symétrique peut être couplée à la sortie du montage en pont et l'entrée du démodulateur peut être couplée à la sortie de l'amplificateur différentiel symétrique et le modulateur est commandé de telle manière que le caractère différentiel du signal de sortie du montage en pont reste conservé.
